# EUROPÄISCHE PATENTSCHRIFT

(11) **EP 0 428 859 B1**
(45) Veröffentlichungstag und Bekanntmachung des Hinweises auf die Patenterteilung: **22.06.1994**
(21) Anmeldenummer: 90119535.4
(22) Anmeldetag: 11.10.1990
(51) Int. Cl.: H05K 7/20

(54) **Elektrische Funktionseinheit insbesondere für die Datentechnik**
Eletric functional unit for data processing
Unité fonctionnelle électrique pour traitement de données

(30) Priorität: 20.10.1989 DE 3935047
(43) Veröffentlichungstag der Anmeldung: 29.05.1991
(73) Patentinhaber: Siemens Nixdorf Informationssysteme Aktiengesellschaft, 33102 Paderborn (DE)
(72) Erfinder: Wessely, Hermann, W-8000 München 60 (DE)
(74) Vertreter: Fuchs, Franz-Josef, Dr.-Ing.

(56) Entgegenhaltungen:
- EP-A- 0 113 794
- GB-A- 2 181 900
- US-A- 3 312 878
- US-A- 4 771 294
- INTERNATIONAL ELECTRONIC MANUFACTURING TECHNOLOGY SYMPOSIUM 26. April 1989, NARA,JAPAN Seiten 83 - 89; HERMANN WESSLEY, SIEMENS AG: 'Packaging system for high performance computer'

## Beschreibung

Die Erfindung betrifft ein Einbausystem für elektrische Funktionseinheiten insbesondere für die Datentechnik, bestehend aus mehreren mit Bauelementen bestückten Leiterplatten, die auf ihrer Bauteileseite an kühlmitteldurchflossenen Kühlplatten anliegen und denen sowohl die Betriebs- als auch die Signalspannungen von außen über Steck- oder Klemmverbindungen zugeführt werden, wobei die Kontaktierung mit den Leiterplatten über Andruckverbinder erfolgt.

In vielen Bereichen der Elektrotechnik, so beispielsweise in der Datentechnik werden, wegen der zunehmenden Zahl von Schaltfunktionen pro Raumeinheit, z.B. bei integrierten Schaltkreisen auch immer höhere Anforderungen an den konstruktiven Teil von elektronischen Geräten gestellt. Die Zuführung zahlreicher Leitungen auf immer kleinerem Raum und die Ableitung der auftretenden Wärme sind dabei wesentliche zu berücksichtigende Faktoren.

Eine Bauweise, die dabei hohen Anforderungen im vorstehend genannten Sinne gerecht wird, ist bereits aus der europäischen Patentschrift 113 794 bekannt. Dort werden die mit Bauelementen insbesondere chipsbestückten mehrlagigen Leiterplatten nebeneinander in einer Ebene in einem mit entsprechenden Ausnehmungen versehenen Gitterrahmen angeordnet, wobei jeder dieser Leiterplatten eine eigene, aus gut wärmeableitendem Material bestehende Kühlplatte auf der bauteiletragenden Seite der Leiterplatte zugeordnet ist. Zusätzlich sorgt eine, sämtliche Einzelkühlplatten kontaktierende gemeinsame, mit Kühlmitel durchflossene weitere Leiterplatte für die Ableitung der den Einzelkühlplatten von den Leiterplatten zugeführten Wärme. Die Verbindung der Leiterplatten mit einer rückseitig an den Gitterrahmen angebrachten Verdrahtungsplatte wird über Andrucksteckverbinder hergestellt, die sich auf der Rückseite der Leiterplatten befinden. Diese planare Anordnung von Flachbaugruppen hat gegenüber den Vorgängersystemen, in denen auf einer Platterplatte mehrere Flachbaugruppen senkrecht zu dieser nebeneinander aufgesteckt wurden, zu einer erheblichen Verdichtung des Raum-Leistungsverhältnisses geführt, läßt jedoch eine weitere Steigerung nur noch in begrenztem Rahmen zu.

Aufgabe der vorliegenden Erfindung ist es daher, ein Einbausystem für elektrische Funktionseinheiten insbesondere für die Datentechnik zu schaffen, das eine weitere Steigerung der Pakkungsdichte von hochintegrierten Bauteilen ermöglicht.

Zur Lösung dieser Aufgabe wird gemäß der Erfindung das Einbausystem derart ausgebildet, daß in wechselnder Folge jeweils mehrere mit Bauteilen bestückte Flachbaugruppen und Kühlplatten flächenparallel hinter- bzw. aufeinander angeordnet sind, so daß sie einen Quader bilden, daß die Kühlplatten mit Kühlmittelkanälen und mit dazu senkrechten Durchbrüchen versehen sind, in denen federnd ausgebildete Andruckkontakte für die Flachbaugruppen untereinander angeordnet sind, daß an den nicht mit Bauelementen bestückten Flächen der beiden äußeren Flachbaugruppen Steckerplatten mit Aussparungen zur Aufnahme von Leitungssteckern für die Signalzuführung anliegen, daß an den beiden anderen Seiten des Quaders die Betriebsspannungen über erste Stromschienen direkt an Potentiallagen der Flachbaugruppen herangeführt werden und daß die Kühlmittelzuführung und die Kühlmittelabfühung für die Kühlplatten an dem dritten Seitenpaar des Quaders erfolgt.

Duch diese Maßnahmen wird eine weitere Verdichtung von Bauelementen pro Volumeneinheit und gleichzeitig durch eine dreidimensionale Leitungsführung eine wesentliche Verkürzung der Verbindungslängen zwischen den integrierten Bausteinen erreicht.

Außerdem wird das Kühlmitel in die unmittelbare Nähe der Wärmequelle geführt und zudem die Geschwindigkeit des Kühlmittels beliebig erhöht, wodurch eine Minimierung des Wärmewiderstandes erfolgt. Eine Minimierung des Spannungsabfalles wird ebenfalls erreicht, da die Spannung auf kürzestem Weg von der Stromversorgung zu den Bausteinen über massive Schienen zugeführt wird. Durch den Einsatz des Andruckkontaktprinzips kan die Signalanschlußdichte je Funktionseinheit wesentliche erhöht werden. Da der Kühlstrom von den elektrischen Komponenten isoliert ist, kann als Kühlmittel Wasser verwendet werden. Durch das Vorsehen eines ausreichend großen Wasserstauraumes (Difenserwirkung) werden gleichmäßige Strömungsverhältnisse und damit gleichmäßige Wärmeabfuhrverhältnisse erhalten.

Die verdrahtungsmäßig günstigsten Bedingungen erhält man, wenn der Quader als Würfel ausgeführt ist.

Die Andruckkontakte können zweckmäßigerweise als Knickfedern ausgebildet sein.

Außerdem ist es möglich, die inneren Leiterplatten der Flachbaugruppen zweiseitig mit Bauteilen zu bestücken.

Montiert man die Baueinheit unmittelbar auf ein Stromversorgungsmodul auf, so lassen sich die Betriebsspannungen an die Stromschienen des Quaders in einfacher Weise über senkrecht dazustehende und entsprechend den unterschiedlichen Potentialen hintereinander, aber in der Länge gestaffelten zweiten Stromschienen, die unmittelbar am Stromversorgungsmodul befestigt sind, bewerkstelligen.

Eine zur Versteifung der mehrlagigen Leiterplatten der Flachbaugruppe dienende beidseitig kupferkaschierte, zwischen den übrigen dünneren Lagen angeordnete dickere Epoxydharzschicht (Versteifungskomplex) kann dabei ebenfalls mehrlagig ausgebildet und die unterschiedlichen Lagen als Potentiallagen verwendet werden.

Eine einfache Verbindung der Stromschienen mit diesen Potentiallagen ergibt sich dadurch, daß die Potentiallagen mit vorstehenden Lappen versehen sind, die unmittelbar mit den ersten Stromschienen verbunden werden.

Anhand der Ausführungsbeispiele nach den FIG 1 bis 9 wird die Erfindung näher erläutert.

Es zeigen
FIG 1 eine schematische Darstellung des Einbausystems
FIG 2 eine schematische Darstellung des Kabelanschlusses für das Einbausystem
FIG 3 eine schematische Darstellung der Kühleinrichtungen des Einbausystems
FIG 4 eine schematische Darstellung der Potentialzuführung für das Einbausystem
FIG 5 einen Querschnitt durch eine mehrlagige Leiterplatte mit Mikroverdrahtung und Versteifungskomplex
FIG 6 die elektrische Verbindung von drei übereinander geschichteten Baugruppen der Funktionseinheit
FIG 7 einen Querschnitt durch eine größere Funktionseinheit des Einbausystems
FIG 8 eine Draufsicht auf eine Flachbaugruppe mit Bestückung mit Bauelementen unterschiedlicher Größe sowie einen Querschnitt durch eine auf dieser Flachbaugruppe liegenden Kühlplatte.

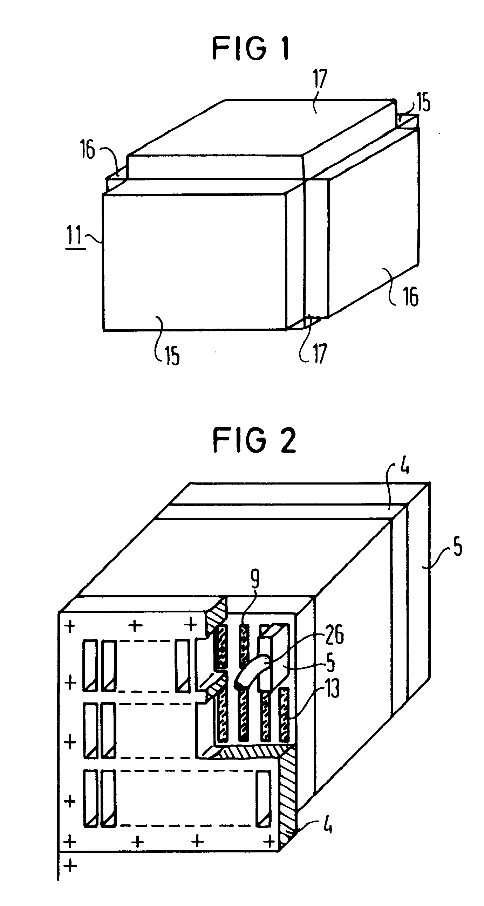

FIG 1 zeigt das grundlegende Konzept des Einbausystems. Die in abwechselnder Reihenfolge übereinander angeordneten Flachbaugruppen und Kühlplatten bilden eine quaderförmige Baueinheit 11, wobei an dem einen Seitenpaar des Quaders der Kabelanschluß 15, am zweiten Seitenpaar die Potentialeinspeisung 16 und am dritten Seitenpaar die Einrichtungen für die Kühlung 17 angebracht sind.

FIG 2 zeigt den Signalkabelanschluß. Er wird an der Vorder- und Rückseite des Quaders vorgenommen, wobei die Leitungsstecker 5 in Steckerplatten 4 eingreifen, die mit Aussparungen 13 versehen sind, aus denen Andruckkontakte 9 herausragen. Diese Andruckkontakte bestehen aus Knickfedern und kontaktieren sich beim Einschieben des Steckers mit entsprechenden Kontaktflächen an dessen Stirnseite.

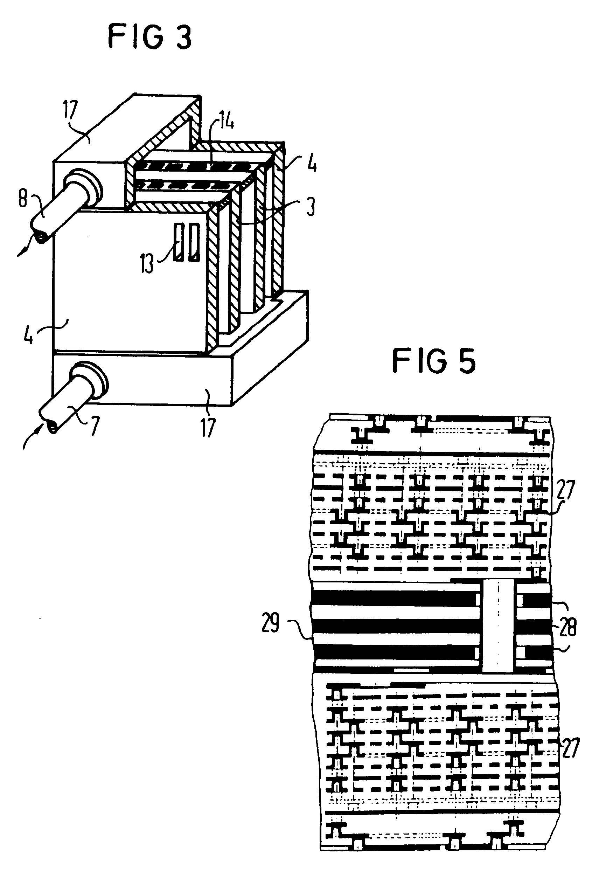

Das Kühlsystem für die Funktionseinheit zeigt FIG 3. Die Zuführung des Kühlmittels erfolgt an der Unterseite über die Zuführungsleitung 7. Das Kühlmittel durchströmt die Kühlmittelkanäle 14 der Kühlplatten 3, die jeweils zwischen den Flachbaugruppen angeordnet sind und tritt an der Oberseite über die Kühlmittelableitung 8 aus der Funktionseinheit wieder aus.

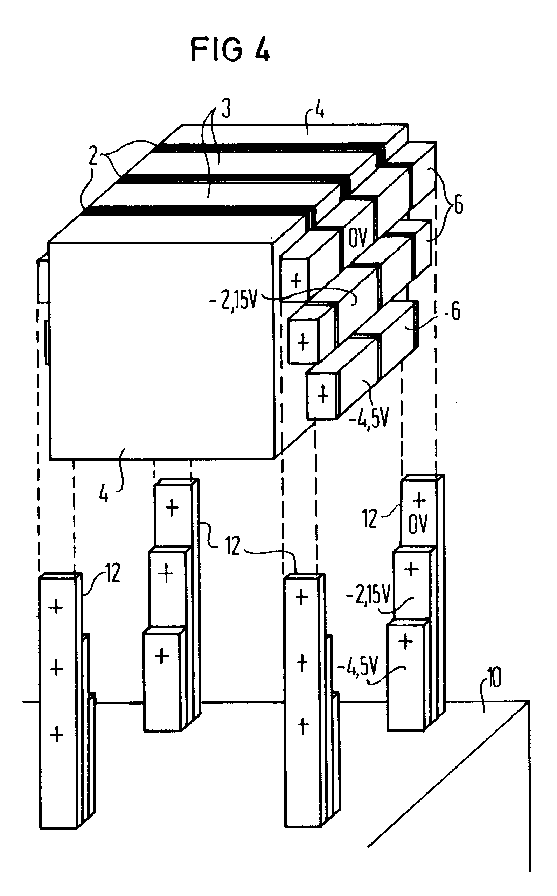

In FIG 4 ist schematisch der Aufbau einer Funktionseinheit gezeigt. Von vorn nach hinten sieht man die Steckerplatte 4, die Flachbaugruppen 2, zwischen denen die Kühlplatten 3 angeordnet sind und am Ende wiederum eine weitere Steckerplatte 4. Auf den Flachbaugruppen 4 befindet sich die Mikroverdrahtung 18. Die Zuführung der Versorgungsspannungen erfolgt seitlich über Stromschienen 6, wobei im vorliegenden Fall die Betriebsspannungen 0 Volt, -2,15 Volt und -4,5 Volt zugeführt werden sollen. Die Leiterplatten der Flachbaugruppen 2 sind mehrlagig ausgebildet und enthalten sowohl Signal- als auch Potentiallagen. Die Potentiallagen sind mit seitlichen Lappen 19 aus dem Quader herausgeführt und dort mit den Stromschienen 6 fest verbunden. Die Stromschienen 6 bestehen aus mehreren hintereinander gereihten Kupferklötzchen zwischen denen die Lappen 19 liegen, die mit den Klötzchen verschraubt sind. Dadurch ist eine einfache Zuführung der Versorgungsspannungen möglich.

Die Versorgungsspannung selbst wird von einer Stromversorgung 10 erzeugt wobei zweite Stromschienen 12 unmittelbar auf dem Stromversorgungsmodul 10 senkrecht nach oben aufgebracht und entsprechend ihrer Spannungen gestaffelt sind. Gleichzeitig sind die waagrechten ersten Stromschienen an der Baueinheit 11 ebenfalls in ihrer Länge gestaffelt, so daß diese unmittelbar in die Stromschienen des Stromversorgungsmoduls eingreifen und mit diesem kontaktieren.

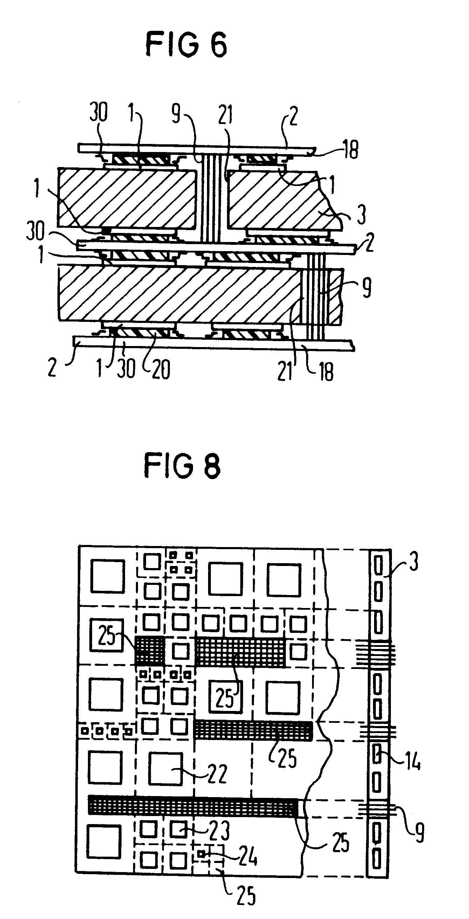

FIG 5 zeigt eine mehrlagige Leiterplatte im Querschnitt wie sie in den Flachbaugruppen 2 eingesetzt ist. In der Mitte dieser mehrlagigen Leiterplatte befindet sich eine gegenüber den übrigen Leiterplatten verstärkte Epoxydharzplatte 29, die als Versteifungskomplex für die mehrschichtige Leiterplatte dient. Diese Epoxydharzschicht 29 ist ebenfalls wiederum mehrlagig im vorliegenden Fall dreilagig, wobei die einzelnen Lagen als Potentiallagen 28 ausgebildet sind.

In FIG 6 ist ein Ausschnitt aus einer Funktionseinheit gezeigt. Zwischen den drei Flachbaugruppen 2 sind jeweils zwei Kühlplatten 3 angeordnet die mit Durchbrüchen 21 versehen sind, in denen sich die Andruckkontakte 9, die als Knickfedern ausgebildet sind, befinden. Diese Andruckkontakte stellen die Verbindung zwischen den einzelnen Flachbaugruppen innerhalb einer Funktionseinheit her.

Die Flachbaugruppen bestehen aus einer Leiterplatte 30, sowie Bauelementen 1, wie z.B. Chips, die auf einer oder beiden Seiten der Leiterplatten 30 angeordnet sind. Zwischen Leiterplatte und Bauelement sind jeweils elastisch federnde Abstandsstücke 20 eingefügt durch die das Bauelement einen definierten Andruck an die jeweilige Kühlplatte erhält, wodurch ein optimaler Wärmeübergang von Bauelement 1 zur Kühlplatte 9 sichergestellt ist. Die Verbindung der Bauelemente 1 auf einer Leiterplatte 30 untereinander erfolgt mit der bereits beschriebenen Mikroverdrahtung 18 nach FIG 5 innerhalb der einzelnen Lagen der mehrlagigen Leiterplatte 30.

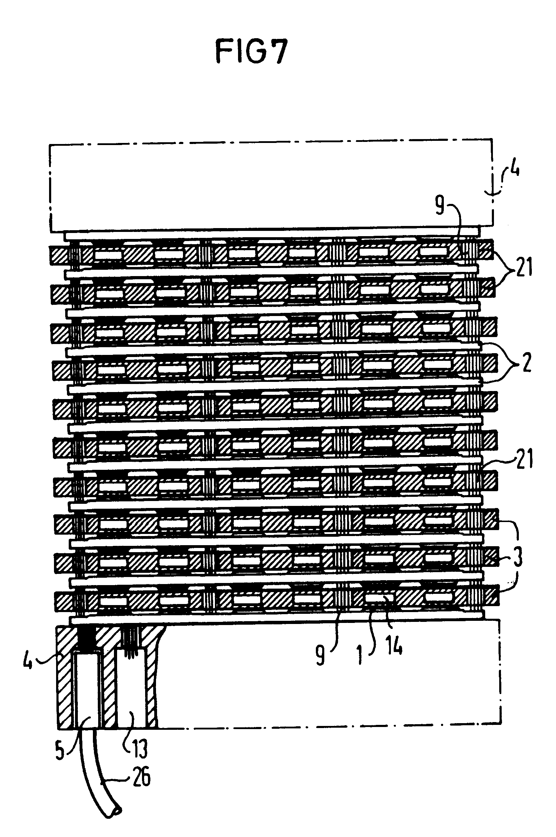

Während bei der Anordnung nach FIG 6 lediglich drei Flachbaugruppen 2 übereinander angeordnet sind zeigt die FIG 7 eine Anordnung von elf Flachbaugruppen 2 übereinander zwischen denen jeweils wiederum Kühlplatten 3 mit entsprechenden Durchbrüchen 21 versehen sind in denen sich die Andruckkontakte 9 befinden. An beiden Seiten eines solchen Leiterplattenpakets sind ebenfalls wieder Steckerplatten 4 vorgesehen in denen sich die Leitungsstecker 5 mit den Signalleitungen 26 befinden, wobei die Leitungsstecker 5, wie bereits beschrieben, in Aussparungen 13 der Steckerplatten 4 eingeschoben werden. Eine Funktionseinheit dieser Art läßt sich maximal mit 720 LSI (Large Skale Integrated Circuits) bestücken. Die Verlustleistung beträgt etwa 40 Kilowatt und es können 50 Millionen Gatterfunktionen damit bewerkstelligt werden.

Neben einer einheitlichen Bestückung von beispielsweise LSI-Chips ist auch eine gemischte Belegung von VLSI 22, LSI 23 und MSI 24 möglich, wie in FIG 8 dargestellt, zwischen denen jeweils Kontaktfeder 25 vorgesehen sind. Rechts neben dem Leiterplattenausschnitt ist in Draufsicht noch einmal eine Kühlplatte gegenüber der Leiterplattendarstellungen um 90 Grad gedreht dargestellt aus der ersichtlich ist, wie die Andruckkontakte jeweils auf die zugehörigen Kontaktfelder auftreffen.

## Patentansprüche

1. Einbausystem für elektrische Funktionseinheiten insbesondere für die Datentechnik, bestehend aus mehreren mit Bauelementen bestückten Leiterplatten, die auf ihrer Bauteileseite an kühlmitteldurchflossenen Kühlplatten anliegen und denen sowohl die Betriebs- als auch die Signalspannungen von außen über Steck- oder Klemmverbindungen zugeführt werden, wobei die Kontaktierung mit den Leiterplatten über Andruckverbinder erfolgt, **dadurch gekennzeichnet,** daß in wechselnder Folge jeweils mehrere Flachbaugruppen (2) und Kühlplatten (3) flächenparallel hinter- bzw. aufeinander angeordnet sind, so daß sie einen Quader bilden, daß die Kühlplatten (3) mit Kühlmittelkanälen (14) und mit dazu senkrechten Durchbrüchen (21) versehen sind, in denen federnd ausgebildete Andruckkontakte (9) für die Flachbaugruppen (2) untereinander angeordnet sind, daß an den nicht mit Bauelementen (1) bestückten Flächen der beiden äußeren Flachbaugruppen Steckerplatten (4) mit Aussparungen (13) zur Aufnahme von Leitungssteckern (5) für die Signalzuführung anliegen, daß an den beiden anderen Seiten des Quaders die Betriebsspannungen über erste Stromschienen (6) direkt an Potentiallagen der Flachbaugruppen (2) herangeführt werden und daß die Kühlmittelzuführung (7) und die Kühlmittelabführung (8) für die Kühlplatten (3) an dem verbleibenden dritten Seitenpaar des Quaders erfolgt.

2. Einbausystem für elektrische Funktionseinheiten nach Anspruch 1, **dadurch gekennzeichnet,** daß der Quader ein Würfel ist.

3. Einbausystem für elektrische Funktionseinheiten nach einem der vorhergehenden Ansprüche, **dadurch gekennzeichnet,** daß die Andruckkontake (9) als Knickfedern ausgebildet sind.

4. Einbausystem für elektrische Funktionseinheiten nach einem der vorhergehenden Ansprüche, **dadurch gekennzeichnet,** daß die inneren Leiterplatten der Flachbaugruppen (2) zweiseitig mit Bauteilen (1) bestückt sind.

5. Einbausystem für elektrische Funktionseinheiten nach einem der vorhergehenden Ansprüche, **dadurch gekennzeichnet,** daß die Baueinheit (11) unmittelbar auf einem Stromversorgungsmodul (10) aufmontiert und die Betriebsspannungszuführung an die Stromschienen (6) der Baueinheit (11) über senkrecht stehende und entsprechend den unterschiedlichen Potentialen hintereinander aber in der Länge gestaffelten zweite Stromschienen (12) die unmittelbar am Stromversorgungsmodul (10) befestigt sind, erfolgt.

6. Einbausystem für elektrische Funktionseinheiten nach einem der vorhergehenden Ansprüche, **dadurch gekennzeichnet,** daß zur Versteifung der Leiterplatten (2) diendende beidseitig kupferkaschierte zwischen den übrigen dünnen Lagen der mehrlagigen Leiterplatten (2) angeordnete dickere Epoxydharzschicht (Versteifungskomplex) ebenfalls mehrlagig ausgebildet und die unterschiedlichen Lagen als Potentiallagen verwendet werden.

7. Einbausystem für elektrische Funktionseinheiten nach einem der vorhergehenden Ansprüche, **dadurch gekennzeichnet,** daß die Potentiallagen (28) mit vorstehenden Lappen (19) versehen sind, die unmittelbar mit den ersten Stromschienen (6) verbunden sind.

## Claims

1. Modular enclosure system for electrical functional units, preferably for data systems, comprising a plurality of printed circuit boards fitted with components which on their component side abut on cooling plates through which coolant flows, and to which both the operating and the signal voltages are supplied from the outside via plug-in or clamp connections, the contact with the printed circuit boards being effected by means of press-on connectors, characterized in that in each case a plurality of flat modules (2) and cooling plates (3) are arranged alternately behind or above one another in a surface-parallel fashion so that they form a cuboid, in that the cooling plates (3) are provided with coolant channels (14) and with breakthroughs (21) perpendicular thereto in which resilient press-on contacts (9) for the flat modules (2) are arranged below one another, in that plug boards (4) with cut-outs (13) for accommodating cable connectors (5) for the signal apply abut on the surfaces of the two outermost flat modules that are not fitted with components (1), in that on the two other sides of the cuboid the operating voltages are supplied directly to potential layers of the flat modules (2) via first conductor rails (6), and in that the coolant supply (7) and the coolant discharge (8) for the cooling plates (3) take place on the remaining third side pair of the cuboid.

2. Modular enclosure system for electrical functional units according to Claim 1, characterized in that the cuboid is a cube.

3. Modular enclosure system for electrical functional units according to one of the preceding claims, characterized in that the press-on contacts (9) are designed as buckling springs.

4. Modular enclosure system for electrical functional units according to one of the preceding claims, characterized in that the inner printed circuit boards of the flat modules (2) are fitted with components (1) on two sides.

5. Modular enclosure system for electrical functional units according to one of the preceding claims, characterized in that the assembly (11) is mounted directly on a power supply module (10) and the operating voltage supply to the conductor rails (6) of the assembly (11) takes place via second conductor rails (12) which are connected directly to the power supply module (10) and which stand perpendicular and, in accordance with the different potential:, behind one another but are successively staggered with respect to their length.

6. Modular enclosure system for electrical functional units according to one of the preceding claims, characterized in that thicker epoxy resin layers (stiffening complex) copper-clad on both sides, which serve to reinforce the printed circuit boards (2) and are arranged between the other thin layers of the multilayer printed circuit boards (2), are likewise of multilayer design and the different layers are used as potential layers.

7. Modular enclosure system for electrical functional units according to one of the preceding claims, characterized in that the potential layers (28) are provided with protruding tabs (19) which are connected directly to the first conductor rails (6).

## Revendications

1. Système de montage pour des unités électriques fonctionnelles, notamment pour la technique de transmission de données, constitué par plusieurs plaquettes à circuits imprimés équipées de composants et qui s'appliquent, au niveau de leur face portant les composants, contre des plaques de refroidissement parcourues par un fluide de refroidissement et auxquelles aussi bien les tensions de service que les tensions de signal sont introduites de l'extérieur par l'intermédiaire de liaisons à enfichage ou de liaisons à serrage, l'établissement du contact avec les plaquettes à circuits imprimés s'effectuant par l'intermédiaire de connecteurs à serrage, caractérisé par le fait que respectivement plusieurs modules plats (2) et plusieurs plaques de refroidissement (3) sont disposés selon une séquence alternée les uns derrière les autres ou les uns au-dessus des autres, avec leurs surfaces parallèles, de sorte qu'ils (elles) forment un parallélépipède, que les plaques de refroidissement (3) sont pourvues de canaux (14) pour le fluide de refroidissement et de passages (21) perpendiculaires à ces canaux et dans lesquels sont disposés les uns au-dessus des autres des contacts à serrage élastiques (9) pour les modules plats (2), que sur les surfaces, qui ne sont pas équipées de composants (1), des deux modules extérieurs plats s'appliquent des plaques de connecteurs (4) comportant des évidements (13) servant à loger des connecteurs de lignes (5) pour l'envoi des signaux, que sur les deux autres côtés du parallélépipède, les tensions de service sont appliquées directement, par l'intermédiaire de premiers rails conducteurs (6), à des couches d'application de potentiel des modules plats (2), et que l'amenée (7) du fluide de refroidissement et l'évacuation (8) du fluide de refroidissement pour les plaques de refroidissement (3) s'effectuent au niveau du troisième couple de côtés restants du parallélépipède.

2. Système de montage pour des unités électriques fonctionnelles suivant la revendication 1, caractérisé par le fait que le parallélépipède est un cube.

3. Système de montage pour des unités électriques fonctionnelles suivant l'une des revendications précédentes, caractérisé par le fait que les contacts à serrage (9) sont réalisés sous la forme de ressorts coudés.

4. Système de montage pour des unités électriques fonctionnelles suivant l'une des revendications précédentes, caractérisé par le fait que les plaquettes à circuits imprimés intérieures des modules plats (2) sont équipées de composants (1) sur leurs deux faces.

5. Système de montage pour des unités électriques fonctionnelles suivant l'une des revendications précédentes, caractérisé par le fait que le composant (11) est monté directement sur un module d'alimentation en courant (10) et que l'application de la tension de service aux rails conducteurs (6) du composant (11) s'effectue par l'intermédiaire de seconds rails conducteurs (12), qui sont verticaux, sont disposés les uns derrière les autres conformément aux différents potentiels ou sont échelonnés du point de vue longueur et qui sont fixés directement au module d'alimentation en courant (10).

6. Système de montage pour des unités électriques fonctionnelles suivant l'une des revendications précédentes, caractérisé par le fait qu'on réalise la couche de résine époxy (complexe de renforcement) plus épaisse, utilisée pour renforcer les plaquettes à circuits imprimés (2), et portant un placage en cuivre sur leurs deux faces et disposée entre les autres couches minces des plaquettes à circuits imprimés (2) à couches multiples, également avec des couches multiples et que les couches différentes sont utilisées comme couches d'application de potentiel.

7. Système de montage pour des unités électriques fonctionnelles suivant l'une des revendications précédentes, caractérisé par le fait que les couches d'application de potentiel (28) comportent des pattes saillantes (19), qui sont reliées directement aux premiers rails conducteurs (6).
